(19) Europäisches Patentamt
European Patent Office
Office européen des brevets

(11) EP 0 755 048 B1

(12) **EUROPEAN PATENT SPECIFICATION**

(45) Date of publication and mention
of the grant of the patent:
**07.11.2001 Bulletin 2001/45**

(51) Int Cl.[7]: **G11B 5/39**, G01R 33/09

(21) Application number: **96304676.8**

(22) Date of filing: **25.06.1996**

(54) **Magnetoresistive recording head**

Magnetoresistiver Aufnahmekopf

Tête d'enregistrement magnétorésistive

(84) Designated Contracting States:
**DE FR GB**

(30) Priority: **18.07.1995 US 503679**

(43) Date of publication of application:
**22.01.1997 Bulletin 1997/04**

(73) Proprietor: **Hewlett-Packard Company,
A Delaware Corporation
Palo Alto, CA 94304 (US)**

(72) Inventors:
• **Brug, James A.
Menlo Park, CA 94025 (US)**

• **Bhattacharyya, Manoj K.
Sunnyvale, CA 94087 (US)**

(74) Representative: **Powell, Stephen David et al
WILLIAMS, POWELL & ASSOCIATES,
4 St Paul's Churchyard
London EC4M 8AY (GB)**

(56) References cited:
**EP-A- 0 101 825**      **EP-A- 0 348 027**
**US-A- 3 860 965**      **US-A- 4 012 781**

• **JOURNAL OF APPLIED PHYSICS, vol. 75, no. 10, PART 02B, 15 May 1994, pages 6531-6533, XP000458203 HARDNER H T ET AL: "1/F NOISE IN GIANT MAGNETORESISTIVE MATERIALS"**

**Description**

The present invention relates generally to recording heads for magnetic storage media. More particularly, the recording head of the present invention incorporates magnetoresistive elements for sensing the magnetic fields recorded on the magnetic storage media and effectively rejects thermal asperity noise.

The data density of magnetic storage devices continues to increase as advances are made in the design of read/write heads and in the materials used to form the magnetic medium. For example, the recent trend toward the use of magnetoresistive (MR) read heads has contributed to the increase in disk drive storage density. An MR read head detects a magnetic field through the resistance change experienced by the MR material as a function of the strength and direction of the detected magnetic field.

Typically, a traditional read/write head is composed of a single inductive device which serves to provide both the writing and reading of data to and from the disk. Having an MR read head that is separate from the write head allows the geometry of the read and write elements to be scaled down, while still allowing the performance of the read and write operations to be optimized.

The demand for higher density drives requires the heads to fly closer and closer to the disk, since higher linear bit densities require smaller bits, which in turn requires the heads to be more closely spaced to the disk in order to read them. At these microscopic levels of separation, the head occasionally comes into contact with the surface of the disk during normal operation, due to movement of the head and to surface roughness (asperities) of the disk. These impacts cause heating of the head, which change the resistance of the magnetoresistive material, and are manifested as noise in the output of the read head. This effect, known as "thermal asperity noise," is a source of error when reading data from the disk, and as heads are made to fly even closer to the recorded media the frequency of head impacts will increase, making the problem worse.

A solution to the problem of thermal asperity noise is disclosed in U.S. Patent No. 3,860,965 to Voegeli. A dual-stripe MR (DSMR) head is described which uses two MR elements operated in differential mode. When the head contacts the disk surface, both elements of the dual-stripe head are subjected to the resulting change in temperature. Because the MR elements are operated differentially, the voltage change induced by the temperature change is rejected; i.e. there is common mode rejection of the noise. The MR materials used in a DSMR read head operate on the basis of the anisotropic magnetoresistive effect, and so typically exhibit changes in resistivity only of about 2%, producing relatively weak differential output signals.

Anisotropic MR devices exhibit changes in resistivity as a function of the square of the cosine of the angle between the direction of the current passing through the device and the direction of the magnetization of the device. Stronger signals are possible from sensors which use the so-called "giant magnetoresistive" (GMR) effect. In such a sensor, the resistivity is modulated as a function of the cosine of the angle between the directions of the magnetizations of two conductive magnetoresistive layers.

One such MR sensor is described in U.S. Patent No. 5,159,513 to Dieny et al. The MR sensor disclosed by Dieny et al. is referred to as a "spin valve," and includes a first layer of ferromagnetic material having a magnetization that is perpendicular to the magnetization of a second layer of ferromagnetic material. The magnetization of one of the layers is fixed (or pinned) so that its direction remains unchanged in the presence of a magnetic field. The magnetization of the other layer rotates upon exposure to a magnetic field, causing a change in resistivity of the sensor.

Since the spin valve structure of the Dieny et al. MR sensor is only a single read element, the prior art device is not capable of providing common mode noise rejection, and therefore would be susceptible to thermal asperity noise. Moreover, the prior art spin valve does not lend itself to a dual-stripe configuration. Although thermal asperity noise would be cancelled by the differential operation, the desired signal generated by each spin valve in response to the sensed magnetic field would also be cancelled due to the differential operation of the device. What is needed is a magnetorsistive read head which provides a signal output greater than that which is possible from present anisotropic MR devices, and which is capable of eliminating or at least minimizing thermal asperity noise.

EP-A-0348027 discloses a magnetoresistive sensing device comprising a first magnetoresistive member and a second member, current passing through the members to produce output voltages, and means for differentially detecting the output voltages to eliminate unwanted charges therein. The disclosure of this document corresponds generally to the introductory part of claim 1.

The invention is directed to a magnetoresistive (MR) sensing device, such as a read head, for sensing magnetic fields on the surface of a magnetic recording medium.

According to the present invention, there is provided a magnetoresistive sensing device comprising: a first portion having a resistivity that is dependent upon the temperature of said sensing device, said resistivity being characterised by a first temperature coefficient of resistance, said resistivity further being variable upon exposure to a magnetic field; a second portion having a resistivity that is dependent upon the temperature of said sensing device; a current source coupled to said first and second portions, providing a current therethrough to produce respectively a first and a second output voltage; said first and second portions each having an ambient resistance; said first portion having a product term including said ambient resistance thereof, first temperature coefficient of resistance and said current therethrough; said second portion having a product term including said ambient resistance thereof, second temperature coefficient of resistance and said current therethrough; said product terms being substantially equal; whereby a variation in the temperature of said sensing device causes said first and second output voltages to change by substantially the same amount, so that differential detection of said output voltages eliminates said changes in said output voltages due to said temperature variations; said second portion being characterised by a resistivity which has a second temperature coefficient of resistance and is substantially invariant with exposure to said magnetic field.

Thus, in embodiments of the present invention, a magnetoresistive sensing head is composed of a first portion and a second portion, each characterized by a room temperature (or ambient) resistance and a temperature coefficient of resistance. The resistivity of both portions is a function of temperature. The resistivity of the first portion, in addition, is a function of the magnetic flux of a sensed magnetic field, while that of the second portion is independent of magnetic flux. The first portion is spaced apart from the second portion by an insulating film. Differential operation of the first and second portions serves to cancel noise caused by thermal asperities. On the other hand, since the signal representing the sensed magnetic field appears only in the first portion, there is no cancellation of the signal by operating the device in differential mode.

In one embodiment of the present invention, the first portion and second portion of the above-described sensing head are first and second adjacent active areas (or regions) formed on a singular magnetoresistive element. Since the two portions are merely adjacent and integral regions of the same element, the heat resulting from thermal asperities will equally affect the two portions. Moreover, the second portion is rendered insensitive to magnetic flux by pinning the magnetization of the second region of the magnetoresistive element. Thus, common mode rejection of thermal asperity noise is provided by differential operation of the sensing head, while preserving the signal of the sensed magnetic field.

The following description more clearly describes exemplary embodiments of the present invention as illustrated in the drawings, in which:

Figure 1 shows a dual-stripe giant magnetoresistive (GMR) read head useful in explaining the present invention.
Figure 2 depicts the structure of one of the two spin valves shown in the Fig. 1.
Figure 3 illustrates an embodiment of an MR sensor for rejecting thermal asperity noise, in accordance with the present invention.
Figure 4 shows an embodiment of an MR sensing device of the present invention which uses a singular MR element.
Figures 5-7 depict alternate arrangements of the individual film layers making up each of the GMR spin valves shown in Fig. 1.

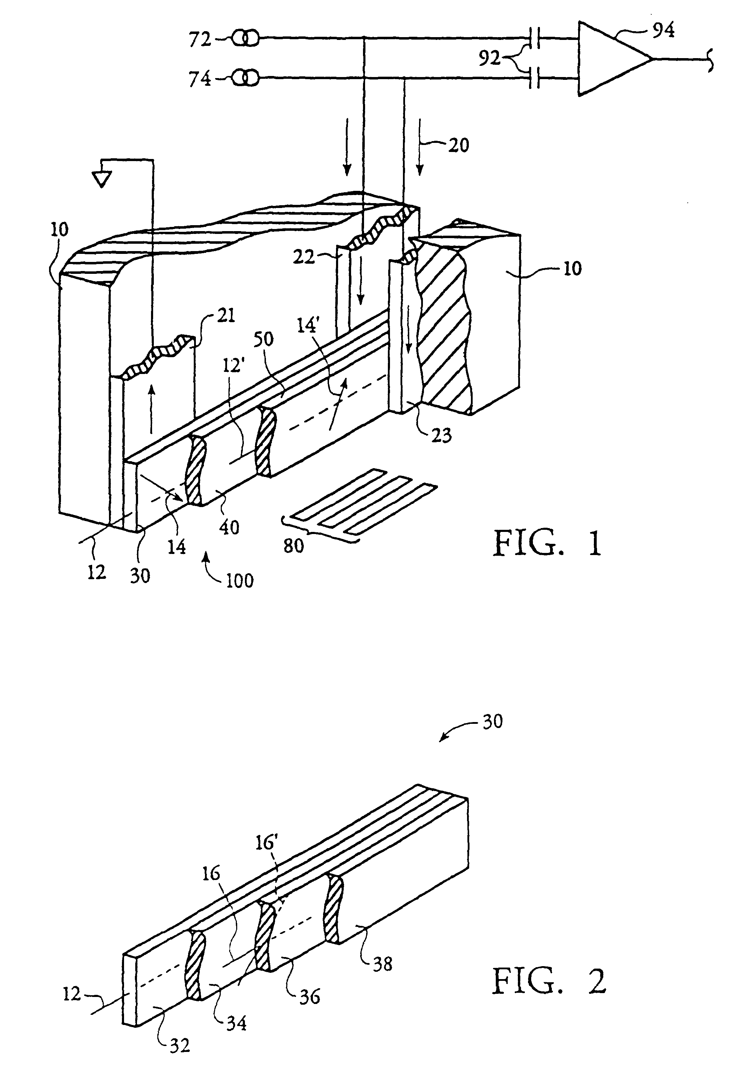

The magnetoresistive read head illustrated in Fig. 1 is a dual-stripe giant magnetoresistive (DSGMR) sensor 100, which serves as the read element of a read/write head used in a storage device such as a disk drive. The write head typically is an inductive element which is well known in the art, and for this reason is not shown in the accompanying diagrams. It is understood that an inductive write head generally is fabricated adjacent to the read sensor in a disk drive application.

Referring to Fig. 1, a cut-away view of a DSGMR sensor or read head 100 shows two elongated magnetoresistive (MR) elements 30, 50 separated by an electrical insulating layer 40. Each of the MR elements is a spin valve structure, which will be further described below with reference to Fig. 2. Magnetic shield layers 10 sandwich the MR elements of the read head 100 to prevent extraneous magnetic fields from being sensed by the read head. The materials used for the magnetic shielding are known in the art. For example, the shields may be made of permalloy material.

Electrical current is applied to each MR element 30, 50 by way of conductors 21-23 carrying current 20 provided by the current sources 72, 74. Alternatively, a single current source may be used, rather than the two current sources shown in the figure. The cut-away view in Fig. 1 shows only one conductor 23 connected to a portion of the MR element 50. However, it is understood that a second conductor is connected to the MR element 50 to provide a return path to ground.

The construction of the MR spin valve elements 30, 50 is shown in Fig. 2, illustrating the components of one of the two spin valves 30. The spin valve is a multi-layered structure composed of a magnetic sense film 32 separated from a magnetic pinned film 36 by a non-magnetic metallic layer 34.

A characteristic of a ferromagnetic material is the magnetization easy axis, which is the axis along which the magnetization of the material lies in the absence of a magnetic field. For example, the sense film 32 shown in Fig. 2 has a longitudinally-oriented magnetization easy axis 12. In the presence of a magnetic field, the magnetization of the sense film is rotated away from the easy axis; i.e. the direction of the magnetization vector of the sense film is rotated relative to the orientation of the easy axis 12. When the magnetic field is removed, the magnetization reverts along its easy axis. Materials which exhibit this effect in relatively low magnetic fields are said to have "soft magnetic properties." The material chosen for the sense film 32 should exhibit soft magnetic properties. Materials suitable for use as the sense film 32 are generally known to those of ordinary skill in the art.

The pinned film 36 is characterized by the fact that its magnetization remains fixed in a given direction, so that the direction of its magnetization vector is unaffected by the presence of magnetic fields up to a predetermined strength. Figure 2 shows a layer, namely the pinning film 38, which serves to pin, or fix, the magnetization of the pinned film 36 by an effect known in the art as exchange coupling. In this case, the magnetization of the pinned film 36 is fixed along a pinned axis 16. The pinning film 38 typically is made of an antiferromagnetic material, which is unaffected by magnetic fields. Alternatively, the pinning film 38 can be made of a high coercivity ferromagnetic material. Both kinds of material are known in the art.

The spin valve 30 shown in Fig. 2 operates according to the giant magnetoresistive effect. The resistivity of the spin valve is a function of the square of the cosine of the angle between the magnetization vectors of the sense film 32 and the pinned film 36. When a magnetic field is present, the magnetization vector of the pinned film remains unchanged, while the magnetization vector of the sense film is rotated by an amount proportional to the magnetic flux of the field. The relative rotation of the two magnetization vectors therefore results in a change in the resistivity of the spin valve 30.

Returning to Fig. 1, operation of the DSGMR sensor can now be explained. In the preferred embodiment, the easy axis of the sense film and the pinned axis of the pinned film of each of the spin valves 30, 50 lie along respective longitudinal axes 12, 12' of the spin valves. In addition, for each spin valve, the pinned magnetization is oriented in the same direction as the magnetization of the sense film. Employing this configuration of magnetization vectors simplifies the fabrication of the spin valves because the same annealing step can be used to set the magnetization of both the sense films and the pinned films. This configuration also results in no magnetic poles at the top and bottom edges of the film layers, and so is inherently a more stable structure than in prior art structures where the pinned layer is oriented transverse to the sense layer. See, for example, Fig. 1 and col. 2, lines 61 and following of the reference to Dieny et al. In addition, by having the pinned magnetizations lie along the longitudinal axes 12, 12' of the spin valves, the pinned films can be made thicker and so produce a larger GMR effect.

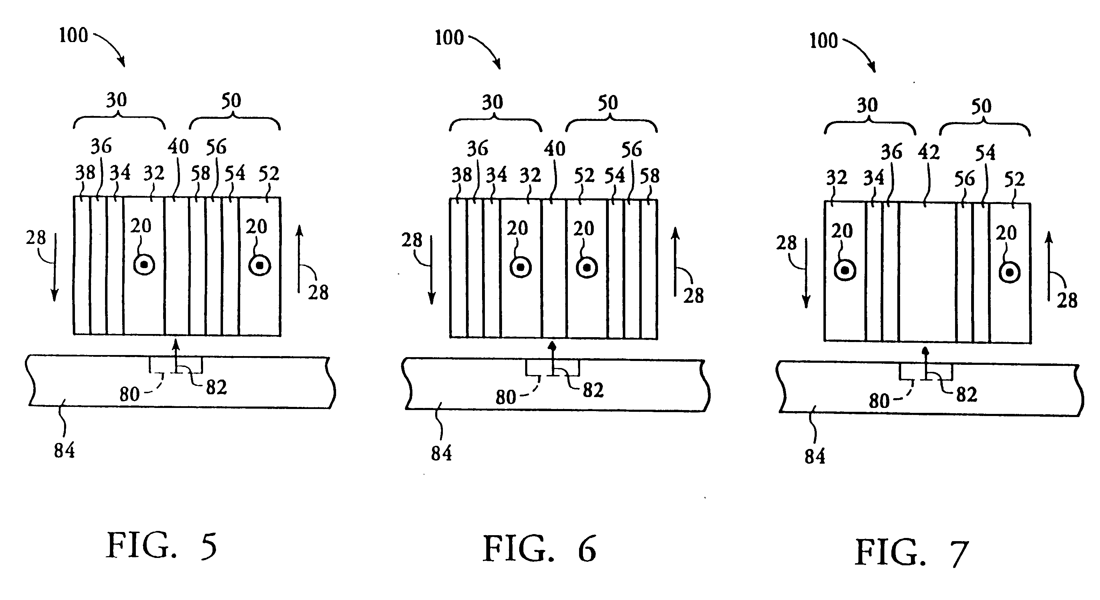

The current 20 provided by the conductors 21-23 flows through each spin valve in the same direction, and so biases the magnetization in each sense film in opposite directions 14, 14', typically on the order-of 45° relative to the longitudinal axis. The reason for the opposed biasing is an understood effect and will be explained below with respect to the description of Figs. 5-7.

The voltage drop across each spin valve 30, 50 is differentially detected by the capacitively coupled differential pre-amp 92, 94. During operation, the magnetic fields of the written bits 80 are presented to the DSGMR read head. The presence of the fields further rotates the biased magnetizations 14, 14' of the spin valves. For a positive polarity magnetic field, each of the magnetizations of the spin valves will be rotated in the counter-clockwise direction. Thus, with respect to the first spin valve 30, there will be a decrease in the angle between the magnetization 14 of the sense film 32 and the magnetization 12 of the pinned film 36, resulting in a decrease in the resistivity of the spin valve. Conversely, with respect to the second spin valve 50, there will be an increase in the angle between the sense film and the pinned film magnetizations 14', 12', thus increasing the resistivity of the second spin valve. Since the voltage drops are detected differentially, the voltage output of the DSGMR read head is the sum of the individual voltage drops across each spin valve.

With respect to the occasional impacts between the DSGMR head and the disk surface, such impacts will induce the same thermal changes in both spin valves 30, 50. The consequent changes in resistivity (and therefore detected voltage) due to the heat change will affect both spin valves equally. Since the voltage drops across the spin valves are differentially detected, there is common mode rejection of the voltage changes due to thermal asperity noise resulting from the impacts.

Turning now to figures 5-7, variations of the preferred embodiment of the DSGMR read head or sensor 100 are shown. In each figure, the view is a cross-section looking down the longitudinal direction of the sensor (see Fig. 1). A cross-section of a portion of the magnetic recording medium 84 diagramatically illustrates the magnetic flux 82 of a data-bit 80 recorded on the medium. The figures show that the film layers of each spin valve 30, 50 can be formed in various combinations. For example, the spin valves 30, 50 in Fig. 5 are attached to the insulation layer 40 such that the sense film 32, 52 of each spin valve faces to the right. Thus, the sense film 32 of one spin valve 30 is formed adjacent to the insulation layer 40, followed by the non-magnetic metallic layer 34, the pinned film 36 and the pinning film 38. On the other hand, the pinning film 58 of the other spin valve 50 is formed adjacent to the insulation layer 40, followed by the pinned film 56, the non-magnetic metallic film 54 and the sense film 52. Figure 6 shows a variation in which the sense films 32, 52 of both spin valves are formed adjacent to the insulation layer 40, with the remaining film layers formed accordingly. In yet another variation, Fig. 7 shows an embodiment in which the pinning films of both spin valves are integrally formed with the insulation layer 42. The pinned films 36, 56 of both spin valves are formed adjacent to the integrally formed pinning-insulation layer 42. The examples illustrated in Figs. 5-7 show that generally the order in which the films of the spin valves are layered is not important, so long as the sense film and the pinned film in each spin valve are separated by the non-magnetic layer 36, 56. The embodiments shown in these figures therefore are merely exemplary, and are not intended to be limiting. A person of ordinary skill in the art will readily understand that various alternate arrangements of the film layers are possible without departing from the intent and spirit of the present invention.

In each of Figs. 5-7, the conductors 21-23 shown in Fig. 1 are attached to the outermost film layers. For example, in Fig. 5, the conductors (not shown) would be attached to the pinning film 38 of one spin valve 30 and to the sense film 52 of the other spin valve 50. Since all the film layers are metallic, current is conducted throughout the entire structure of the spin valve. The flow of current 20 is shown coming out of the page, as indicated by the standard notation of a circle with a dot in the center. The magnetic fields 28 formed by the current are directed according to the so-called "right-hand" rule. Thus, with respect to Figs. 5-7, the magnetic field on the right side of the sensor points upwardly, while the field on the left is downwardly directed. These magnetic fields serve to bias the magnetizations 14, 14' of the sense films 32, 52 in the directions as shown in Fig. 1.

Returning now to Figs. 1 and 2, in another embodiment of the present invention, the magnetization vector of the pinned film in each spin valve 30, 50 may be directed along an axis that is transverse to the magnetization easy axis of the corresponding sense film. Referring to the spin valve 30 shown in Fig. 2, this alternate embodiment is illustrated by the pinned film 36 having a pinned axis 16' that is oriented transverse to the easy axis 12 of the sense film 32. The pinned film of the other spin valve 50 has a similarly oriented pinned axis. In this embodiment, the pinned magnetization of each spin valve 30, 50 has an anti-parallel direction relative to the other. Thus, the magnetization vectors of the pinned films lie along the same axis 16', but are directed in the opposite directions; i.e. the angle between the vectors is 180°.

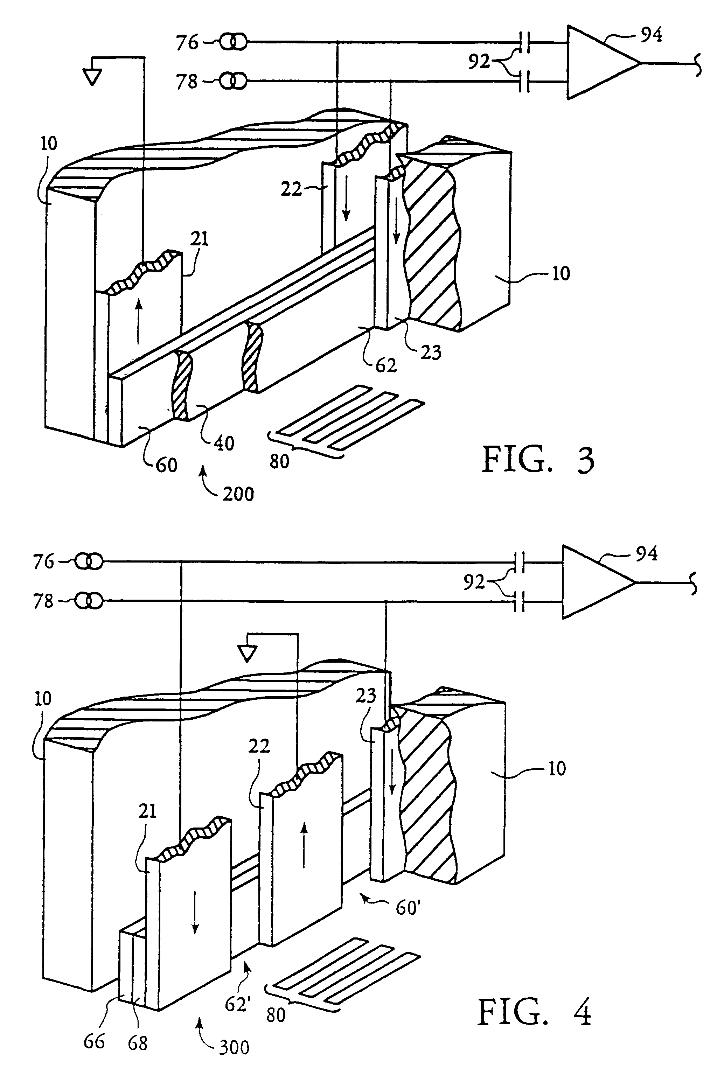

Reference is now made to Fig. 3 in an embodiment of the present invention. A magnetoresistive (MR) sensor 200 is shown, composed of a magnetoresistive element 60 and a heat sensitive-only element 62 separated from the MR element by an electrical insulation layer 40. The magnetic shielding 10 and the current carrying conductors 21-23 are the same as those shown in Fig. 1. The output voltages of the active elements, i.e. the MR element 60 and the heat sensitive-only element 62, are differentially detected by the capacitively coupled differential pre-amp 92, 94.

The MR element 60 may be any of a number of magnetoresistive elements known in the art, including the spin valve structure as shown in Fig. 2, and an MR head that uses a soft adjacent layer as the biasing element as described in U.S. Patent No. 4,024,489 to Bajorek et al. The heat sensitive-only element 62 is composed of material which exhibits a resistance change only when the temperature of the element changes. The insulation layer 40 is typically 50 nanometers thick.

The materials used to fabricate the two active elements 60, 62 are characterized by their resistance at room temperature (ambient resistance), their temperature coefficient of resistivity, and by the amount of current being passed through them. The output voltages of each the elements 60, 62 as functions of the temperature are defined by the following:

$$\Delta V_{60} = i_{60}\Delta R_{60}$$

$$= i_{60}R_{60}\alpha_{60}\Delta T \qquad \text{(Eqn. 1)}$$

$$\Delta V_{62} = i_{62}\Delta R_{62}$$

$$= i_{62}R_{62}\alpha_{62}\Delta T \qquad \text{(Eqn. 2)}$$

where

| | |
|---|---|
| $\Delta V_{60}$ | change in output voltage of MR element 60 due to change in temperature, |
| $i_{60}$ | current through MR element, |
| $\Delta R_{60}$ | change in resistance of MR element due to change in temperature, |
| $R_{60}$ | room temperature (ambient) resistance of MR element, |
| $\alpha_{60}$ | temperature coefficient of resistivity of MR element, |
| $\Delta v_{62}$ | change in output voltage of heat sensitive element (62) due to change in temperature, |
| $i_{62}$ | current through heat sensitive element, |
| $\Delta R_{62}$ | change in resistance of heat sensitive element due to change in temperature, |
| $R_{62}$ | room temperature (ambient) resistance of heat sensitive element, |
| $\alpha_{62}$ | temperature coefficient of resistivity of heat sensitive element, and |
| $\Delta T$ | temperature change experienced by both elements 60, 62. |

Since only the MR element 60 is sensitive to the magnetic fields of the written bits on the magnetic medium, the differential operation of the pre-amp 94 will not cancel the signal produced by the sensed bits. On the other hand, both the MR element 60 and the heat sensitive element 62 will exhibit a response to the heat created by the occasional impacts between the sensor 200 and the disk (not shown). Thus, by adjusting the parameters in Eqns. 1 and 2 appropriately, the voltage changes in each of the active elements 60, 62 due to thermal asperities can be made equal, so that the differential operation of the amp 94 will result in common mode rejection of the thermal asperity noise.

$$0 = \Delta V_{60} - \Delta V_{62}$$

$$= \Delta T(i_{60}R_{60}\alpha_{60} - i_{62}R_{62}\alpha_{62}) \qquad \text{(Eqn. 3)}$$

Equation 3 shows that thermal asperity noise cancellation can be achieved by adjusting the current, the ambient resistance and/or the resistivity coefficient for each of the two active elements 60, 62 so that the product terms $(i*R*\alpha)$ are made equal.

The heat sensitive-only element 62 need not be non-magnetic. By making the heat sensitive element from a material such as a permanent magnet or a magnetically soft film, design advantages may be realized in setting the appropriate bias point in the MR element 60. For instance, if the MR element 60 is a spin valve, then the field induced by a heat sensitive element 62 made from a permanent magnet could be used to reduce the field that is produced by the pinned film in the spin valve.

Figure 4 shows yet another embodiment in which an MR sensor 300 is shown composed of a single MR element 66, having two active areas 60', 62'. The first active region 60' of the MR element 66 is sensitive to the magnetic field of the written bits 80, in that the magnetization of the active region is rotated in the presence of a magnetic field. The second active area 62' of the MR element 66, on the other hand, is magnetically inactive. An exchange film 68 formed along that portion of the MR element 66 which defines the second active area 62' serves to pin, or fix, the magnetization of that portion of the MR element. Since an exchange film is commonly used in the fabrication of present MR heads, pinning the second active region in this manner is easily incorporated into the fabrication of a read head in accordance with this embodiment of the present invention.

The current sources 76, 78 provide current to the MR element 66 through the conductors 21-23. The current enters the MR element at each end, and flows to ground through a conductor 22 which serves to ground both of the active areas 60', 62'. This common ground provides a common reference potential for detecting the output voltage of each of the active regions.

In operation, the magnetization of the first active area 60' will change in response to the magnetic fields of the recorded data 80, while the magnetization of the second active area 62' remains fixed. Therefore, the differential op-amp 94 will not cancel the signal generated by the detection of the data. However, despite the physical displacement of the two active regions along the length of the single MR element 66, any heat generated by thermal asperities will be generated over the entirety of the micrometer-sized region of the active areas 60', 62', and so will still result in common mode rejection by the differential operation of the op-amp 94.

**Claims**

1.  A magnetoresistive sensing device (200, 300) comprising:

    a first portion (60, 60') having a resistivity that is dependent upon the temperature of said sensing device, said resistivity being **characterised by** a first temperature coefficient of resistance, said resistivity further being variable upon exposure to a magnetic field (82);
    a second portion (62, 62') having a resistivity that is dependent upon the temperature of said sensing device;
    a current source (76, 78) coupled to said first and second portions (60, 60'; 62, 62'), providing a current therethrough to produce respectively a first and a second output voltage;
    said first and second portions each having an ambient resistance;
    said first portion (60, 60') having a product term including said ambient resistance thereof, first temperature coefficient of resistance and said current therethrough;
    said second portion (62, 62') having a product term including said ambient resistance thereof, second temperature coefficient of resistance and said current therethrough;
    said product terms being substantially equal;
    whereby a variation in the temperature of said sensing device (200, 300) causes said first and second output voltages to change by substantially the same amount, so that differential detection of said output voltages eliminates said changes in said output voltages due to said temperature variations; said second portion (62, 62') being **characterised by** a resistivity which has a second temperature coefficient of resistance and is substantially invariant with exposure to said magnetic field (82).

2. The magnetoresistive sensing device (300) of claim 1, wherein said first and second portions are integrally formed first and second regions (60', 62'), respectively, of a singular magnetoresistive element (66), said second region (62') having an exchange biasing film (68) disposed thereon, thereby pinning said magnetization of said second portion.

3. The magnetoresistive sensing device (200) of claim 1, further including a third portion (40) disposed between said first and second portions (60, 62), said third portion (40) being electrically insulative and having a thickness of at most 100 nanometers, said first portion (60) being a spin valve, and said second portion (62) being one of a non-magnetic material and a permanent magnet.

4. The magnetoresistive sensing device (200) of claim 1, wherein said first portion (60) is a spin valve, including a pinned film (36) and a sense film (32).

5. The magnetoresistive sensing device (200) of claim 4, wherein said pinned film (200) further includes a pinning layer (38) and a pinned layer (36).

6. The magnetoresistive sensing device (200) of claim 5, wherein said pinning layer is integrally formed with an insulation layer.

**Patentansprüche**

1. Eine magnetoresistive Erfassungsvorrichtung (200, 300), die folgende Merkmale aufweist:

einen ersten Abschnitt (60, 60') mit einem spezifischen Widerstand, der von der Temperatur der Erfassungsvorrichtung abhängig ist, wobei der spezifische Widerstand durch einen ersten Temperaturkoeffizienten des Widerstandswerts gekennzeichnet ist, und wobei der spezifische Widerstand ferner auf die Einwirkung eines Magnetfelds (82) hin variabel ist;

einen zweiten Abschnitt (62, 62') mit einem spezifischen Widerstand, der von der Temperatur der Erfassungsvorrichtung abhängig ist;

eine Stromquelle (76, 78) die mit dem ersten und dem zweiten Abschnitt (60, 60'; 62, 62') gekoppelt ist und jeweils einen Strom durch dieselben liefert, um eine erste beziehungsweise eine zweite Ausgangsspannung zu erzeugen;

wobei der erste und der zweite Abschnitt jeweils einen Umgebungswiderstandswert aufweisen;

wobei der erste Abschnitt (60, 60') einen Produktterm aufweist, der den Umgebungswiderstandswert desselben, den ersten Temperaturkoeffizienten des Widerstandswerts und den Strom durch denselben umfaßt;

wobei der zweite Abschnitt (62, 62') einen Produktterm aufweist, der den Umgebungswiderstandswert desselben, den zweiten Temperaturkoeffizienten des Widerstandswerts und den Strom durch denselben umfaßt;

wobei die Produktterme im wesentlichen gleich sind;

wodurch eine Schwankung der Temperatur der Erfassungsvorrichtung (200, 300) bewirkt, daß sich die erste und die zweite Ausgangsspannung um im wesentlichen den gleichen Betrag ändern, so daß die differentiale Erfassung der Ausgangsspannungen die Änderungen der Ausgangsspannungen aufgrund der Temperaturschwankungen eliminiert;

wobei der zweite Abschnitt (62, 62') charakterisiert ist durch einen spezifischen Widerstand, der einen zweiten Temperaturkoeffizienten des Widerstandswerts aufweist und gegenüber der Einwirkung des Magnetfelds (82) im wesentlichen invariant ist.

2. Die magnetoresistive Erfassungsvorrichtung (300) gemäß Anspruch 1, bei der der erste und der zweite Abschnitt eine erste bzw. zweite Region (60', 62') eines einzelnen magnetoresistiven Elements (66) sind, die einstükkig gebildet sind, wobei auf der zweiten Region (62') ein vorspannender Austauschfilm (68) angeordnet ist, wodurch die Magnetisierung des zweiten Abschnitts festgehalten wird.

3. Die magnetoresistive Erfassungsvorrichtung (200) gemäß Anspruch 1, die ferner einen dritten Abschnitt (40) umfaßt, der zwischen dem ersten und dem zweiten Abschnitt (60, 62) angeordnet ist, wobei der dritte Abschnitt (40) elektrisch isolierend ist und eine Dicke von höchstens 100 Nanometer aufweist, und wobei der erste Abschnitt (60) ein Spinventil und der zweite Abschnitt (62) entweder ein nicht-magnetisches Material oder ein Permanentmagnet ist.

4. Die magnetoresistive Erfassungsvorrichtung (200) gemäß Anspruch 1, bei der der erste Abschnitt (60) ein Spinventil ist, das einen festgehaltenen Film (36) und einen Erfassungsfilm (32) umfaßt.

5. Die magnetoresistive Erfassungsvorrichtung (200) gemäß Anspruch 4, bei der der festgehaltene Film (36) ferner eine festhaltende Schicht (38) und eine festgehaltene Schicht (36) umfaßt.

6. Die magnetoresistive Erfassungsvorrichtung (200) gemäß Anspruch 5, bei der die festhaltende Schicht einstükkig mit einer Isolationsschicht gebildet ist.

**Revendications**

1. Dispositif de détection magnétorésistif (200, 300)
    comprenant :

   une première partie (60, 60') ayant une résistivité qui dépend de la température dudit dispositif de détection, ladite résistivité étant **caractérisée par** un premier coefficient de température de résistance, ladite résistivité étant, de plus, variable lors de l'exposition à un champ magnétique (82) ;
   une deuxième partie (62, 62') ayant une résistivité qui dépend de la température dudit dispositif de détection ;
   une source de courant (76, 78) couplée auxdites première et deuxième parties (60, 60' ; 62, 62'), fournissant un courant à travers celles-ci afin de produire, respectivement, une première et une deuxième tension de sortie ;
   lesdites première et deuxième parties ayant chacune une résistance à température ambiante ;
   ladite première partie (60, 60') ayant un terme de produit comprenant ladite résistance à température ambiante de celle-ci, le premier coefficient de température de résistance et ledit courant circulant à travers celle-ci ;
   ladite deuxième partie (62, 62') ayant un terme de produit comprenant ladite résistance à température ambiante de celle-ci, le deuxième coefficient de température de résistance et ledit courant circulant à travers celle-ci ;
   lesdits termes de produit étant sensiblement égaux ;
   de telle manière qu'une variation de la température dudit dispositif de détection (200, 300) provoque une variation desdites première et deuxième tensions de sortie sensiblement de la même quantité, de sorte que la détection différentielle desdites tensions de sortie élimine lesdites variations desdites tensions de sortie dues auxdites variations de température ;
   ladite deuxième partie (62, 62') étant **caractérisée par** une résistivité qui a un deuxième coefficient de température de résistance et qui est sensiblement invariante lors de l'exposition audit champ magnétique (82).

2. Dispositif de détection magnétorésistif (300) selon la revendication 1, dans lequel lesdites première et deuxième parties sont les première et deuxième régions (60', 62'), respectivement, formées d'un seul tenant, d'un élément magnétorésistif singulier (66), ladite deuxième région (62') comportant un film de polarisation d'échange (68) disposé sur celle-ci, de ce fait, fixant ladite aimantation de ladite deuxième partie.

3. Dispositif de détection magnétorésistif (200) selon la revendication 1, comprenant, de plus, une troisième partie (40) disposée entre lesdites première et deuxième parties (60, 62), ladite troisième partie (40) étant électriquement isolante et ayant une épaisseur d'au plus 100 nm, ladite première partie (60) étant une vanne de spin et ladite deuxième partie (62) étant l'un d'un matériau non-magnétique et d'un aimant permanent.

**4.** Dispositif de détection magnétorésistif (200) selon la revendication 1, dans lequel ladite première partie (60) est une vanne de spin, comprenant un film à aimantation fixée (36) et un film de détection (32).

**5.** Dispositif de détection magnétorésistif (200) selon la revendication 4, dans lequel ledit film à aimantation fixée (200) comprend, de plus, une couche de fixation d'aimantation (38) et une couche à aimantation fixée (36).

**6.** Dispositif de détection magnétorésistif (200) selon la revendication 5, dans lequel ladite couche de fixation d'aimantation est formée d'un seul tenant avec une couche isolante.

FIG. 1

FIG. 2

FIG. 3

FIG. 4

FIG. 5

FIG. 6

FIG. 7

EP 0 755 048 B1